Europäisches Patentamt

European Patent Office

Office européen des brevets

(11) Veröffentlichungsnummer: **0 354 168**
**A2**

## EUROPÄISCHE PATENTANMELDUNG

(21) Anmeldenummer: 89730174.3

(22) Anmeldetag: 27.07.89

(51) Int. Cl.5: **H 04 N 1/10**
**H 04 N 1/18, H 04 N 1/40**

(30) Priorität: 04.08.88 DE 3826763

(43) Veröffentlichungstag der Anmeldung:
07.02.90 Patentblatt 90/06

(84) Benannte Vertragsstaaten: **DE FR GB IT NL**

(71) Anmelder: **Siemens Aktiengesellschaft**
**Wittelsbacherplatz 2**
**D-8000 München 2 (DE)**

(72) Erfinder: **Bayat, Behrooz, Dr. rer. nat.**
**Fasaneriestrasse 13**
**D-8000 München 19 (DE)**

**Hoheisel, Martin, Dr. rer. nat.**
**Görzer Strasse 97**
**D-8000 München 90 (DE)**

(54) **Verfahren und Vorrichtung zum bildpunktweisen Lesen optischer Informationen.**

(57)     Bei einem Verfahren zum bildpunktweisen Lesen optischer Informationen werden parallel an einer gemeinsamen Ausleseschaltung angeschlossene Bildsensorelemente nacheinander mit den von ihnen zu erfassenden Bildpunktinformationen belichtet, wobei jedesmal mittels der Ausleseschaltung die Fotoströme aller Bildsensorelemente als Summensignal erfaßt werden. Das Summensignal enthält als Nutzsignalanteil den Hellstrom des jeweils belichteten Bildsensorelements und als Rauschanteil die Summe aller Dunkelströme der übrigen unbelichteten Bildsensorelemente, so daß mit zunehmender Anzahl von Bildsensorelementen das Signal/Rausch-Verhältnis schlechter wird.

Zur Verbesserung des Signal/Rausch-Verhältnisses werden Fotodioden (23) als Bildsensorelemente verwendet und mittels der Ausleseschaltung (25) die von ihnen gemeinsame Leerlaufspannung als auswertbares Signal erfaßt.

FIG 4

EP 0 354 168 A2

Bundesdruckerei Berlin

# Beschreibung

## Verfahren und Vorrichtung zum bildpunktweisen Lesen optischer Informationen

Die Erfindung betrifft ein Verfahren zum bildpunktweisen Lesen optischer Informationen, bei dem aus einer Mehrzahl von parallel an einer gemeinsamen Ausleseschaltung angeschlossenen Bildsensorelementen die einzelnen Bildsensorelemente nacheinander mit den von ihnen zu erfassenden Bildpunktinformationen belichtet werden und dabei jedesmal mittels der Ausleseschaltung ein von jeweils allen Bildsensorelementen gemeinsam erzeugtes elektrisches Signal erfaßt wird.

Ein derartiges Verfahren ist aus der DE-OS 35 19 263 im Zusammenhang mit einer Abtasteinrichtung zur optischen Abtastung einer flächenhaften Vorlage bekannt. Bei der bekannten Abtasteinrichtung sind in einer ersten Ebene eine Vielzahl von zeilenweise angeordneten Fotoleiterstreifen ausgebildet, die jeweils aus einzelnen, in Zeilenrichtung angeordneten und in Parallelschaltung an einer Ausleseschaltung angeschlossenen Bildsensorelementen bestehen. In einer zweiten parallelen Ebene sind quer zu den Fotoleiterstreifen verlaufende Beleuchtungselemente zueinander parallel angeordnet, so daß jedes Beleuchtungselement jeden einzelnen Fotoleiterstreifen im Bereich jeweils eines seiner Bildsensorelemente kreuzt. Durch sukzessive Ansteuerung der Beleuchtungselemente wird eine optisch abzutastende Vorlage quer zur Zeilenrichtung der Fotoleiterstreifen spaltenweise nacheinander beleuchtet, so daß in den Kreuzungsbereichen der Beleuchtungselemente mit jedem einzelnen Fotoleiterstreifen das von der Vorlage reflektierte Licht als optische Information nacheinander die Bildsensorelemente des betreffenden Fotoleiterstreifens belichtet. Bei der bekannten Abtasteinrichtung bestehen die Bildsensorelemente aus Fotoleiterelementen, deren belichtungsabhängige Fotoströme in der jedem Fotoleiterstreifen jeweils zugeordneten Ausleseschaltung als ein von allen Fotoleiterelementen gemeinsam erzeugtes elektrisches Signal gemessen werden. Das gemessene elektrische Signal enthält als Nutzsignalanteil den Hellstrom des jeweils momentan belichteten Fotoleiterelements und als störenden Rauschanteil die Summe der Dunkelströme aller übrigen unbelichteten Fotoleiterelemente. Je größer daher die Anzahl der parallelen Fotoleiterelemente des Fotoleiters ist und je geringer der Helligkeitskontrast zwischen dem jeweils belichteten Fotoleiterelement und den unbelichteten Fotoleiterelementen ist, umso ungünstiger ist das Signal/Rausch-Verhältnis des gemessenen Signals.

Bei einem aus der DE-05 36 01 658 bekannten Verfahren zum bildpunktweisen Lesen optischer Informationen entlang einer Zeile finden als Bildsensorelemente Fotodioden Verwendung, die entlang der Zeile angeordnet sind. Die Fotodioden werden unter Ausnutzung ihrer typischen Strom-Spannungs-Kennliniencharakteristik jeweils mit einer negativen Spannung zwischen Anode und Kathode in Sperrichtung betrieben, so daß in jeder Fotodiode ein spannungsunabhängiger und nur noch von der Belichtung der betreffenden Fotodiode abhängiger Fotostrom fließt. Jeder Fotodiode ist jeweils eine eigene Ausleseschaltung zugeordnet, so daß das Problem einer Überlagerung der von den Fotodioden erzeugten Fotoströme nicht gegeben ist.

Der Erfindung liegt die Aufgabe zugrunde, bei parallel an einer Ausleseschaltung angeschlossenen Bildsensorelementen ein verbessertes Signal/Rausch-Verhältnis des gemessenen Signals zu erzielen.

Gemäß der Erfindung wird diese Aufgabe dadurch gelöst, daß bei dem Verfahren der eingangs angegebenen Art als Bildsensorelemente Fotodioden verwendet werden und daß mit Hilfe der Ausleseschaltung die von allen Fotodioden gemeinsam erzeugte Leerlaufspannung erfaßt wird.

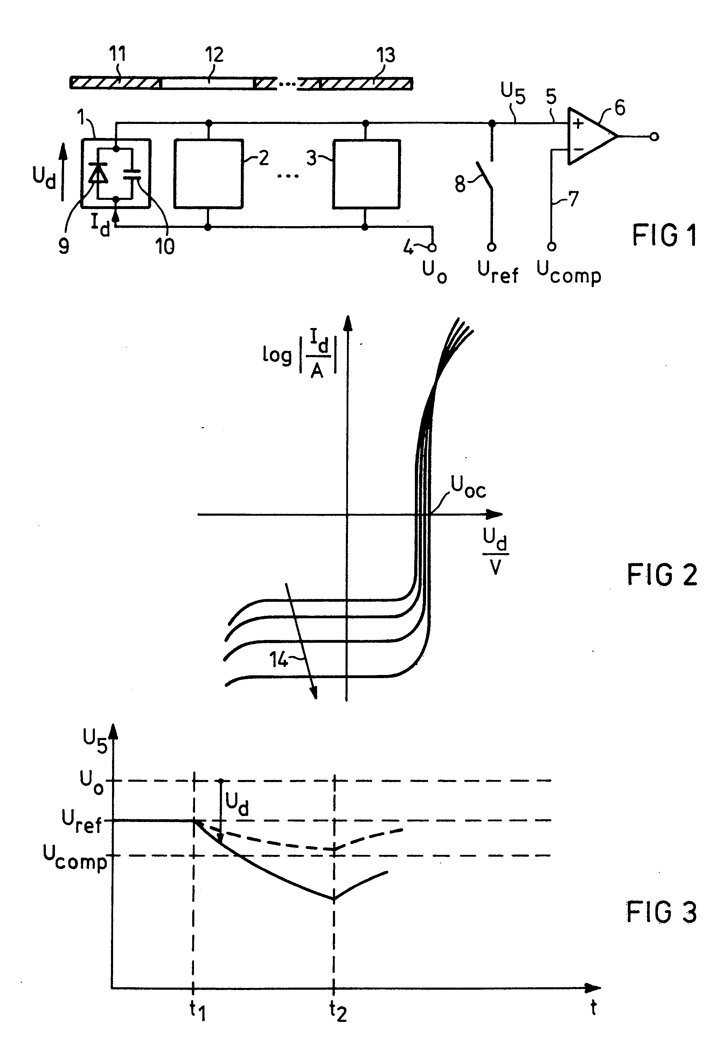

Der wesentliche Vorteil des erfindungsgemäßen Verfahrens liegt darin, daß die gemessene Leerlaufspannung im Unterschied zu den Fotoströmen keine additive Größe ist, sondern durch die jeweils am stärksten belichtete Fotodiode bestimmt ist, so daß ein vergleichsweise hohes Signal/Rausch-Verhältnis des gemessenen Signals erreicht wird. Zwar erleidet die Leerlaufspannung der jeweils momentan belichteten Fotodiode wegen der großen Strombelastung durch die unbelichteten Fotodioden einen Spannungsabfall, jedoch wirkt sich der Einfluß der jeweils unbelichteten Fotodioden bei der Erfassung der Leerlaufspannung bei weitem geringer aus als bei der bekannten Fotostromerfassung. Außerdem sind die Auswirkungen einer in der Praxis kaum vermeidbaren Hintergrundstrahlung, der die jeweils unbeleuchteten Fotodioden ausgesetzt sind, auf das Signal/Rausch-Verhältnis bei dem erfindungsgemäßen Verfahren vergleichsweise gering. Im einzelnen werden die vorstehend genannten Sachverhalte im speziellen Beschreibungsteil anhand der Figuren 1 bis 3 näher erläutert.

Gemäß der Erfindung ist bei einer Vorrichtung zur Durchführung des Verfahrens der eingangs angegebenen Art vorgesehen, daß Bildsensorelemente, die in einer Mehrzahl parallel an einer gemeinsamen Ausleseschaltung angeschlossen und einzeln nacheinander belichtbar sind, aus Fotodioden bestehen und daß die Ausleseschaltung einen mit den Fotodioden verbundenen Eingang zur Leerlaufspannungserfassung aufweist. Hierbei ergibt sich als weiterer Vorteil der erfindungsgemäßen Leerlaufspannungserfassung, daß die Fotodioden bei gleichbleibender Signalhöhe der Leerlaufspannung in sehr geringer Baugröße ausgebildet sein können, so daß eine sehr hohe räumliche Auflösung beim bildpunktweisen Lesen von optischen Informationen erreichbar ist. Im Unterschied zu dem Fotostrom der Fotodioden ist nämlich die Leerlaufspannung von der Größe der Fotodioden unabhängig. Ferner wird durch die geringe Baugröße der Fotodioden eine Verbesserung ihres dynamischen Signalverhaltens erreicht, weil mit zunehmender Verringerung der Baugröße der Fotodioden auch ihre Eigenkapazitäten abnehmen.

Die Fotodioden bestehen vorzugsweise jeweils aus einer Schicht aus wasserstoffhaltigem amorphem Silizium (a - Si:H), die zwischen zwei metallisch leitenden Elektroden eingebettet ist, von denen eine Elektrode transparent ist. Derartige Fotodioden zeichnen sich durch eine hohe Fotoempfindlichkeit und eine hohe Ansprechgeschwindigkeit aus. Ferner lassen sich Fotodioden auf der Basis von amorphem Silizium fertigungstechnisch einfach und im Hinblick auf die oben genannte geringe Baugröße in sehr feinen Strukturen in Dünnschichttechnik auf einem Substrat realisieren.

Entsprechend einer vorteilhaften Ausbildung der erfindungsgemäßen Vorrichtung besteht die transparente Elektrode aus Indium-Zinnoxid ($In_2O_3$-$SnO_2$; ITO). Damit wird eine Leerlaufspannung in der Größenordnung von ca. 160 mV im oberen Bereich der für das Lesen von Bildinformationen in Betracht kommenden Beleuchtungsstärke bei einer zum Lesen der Bildpunktinformationen ausreichenden Ansprechgeschwindigkeit erreicht.

Eine etwa um den Faktor 2,5 größere Lerrlaufspannung bei geringerer Ansprechgeschwindigkeit wird gemäß einer alternativen Ausbildung dadurch erreicht, daß die transparente Elektrode aus Palladium (Pd) besteht.

Die Verwendbarkeit der erfindungsgemäßen Vorrichtung, wie z. B. ihr Einsatz in optischen Abtasteinrichtungen, wird in entscheidendem Maße von dem dynamischen Signalverhalten und der Signalhöhe der meßbaren Leerlaufspannung bestimmt; insbesondere ist für eine Graustufenerkennung eine hohe Leerlaufspannung erforderlich. In diesem Zusammenhang wird eine wesentliche Steigerung der Empfindlichkeit und der Ansprechgeschwindigkeit der erfindungsgemäßen Vorrichtung dadurch erreicht, daß jede Fotodiode aus mindestens zwei, in Serie geschalteten Fotodiodenelementen besteht. Diese Maßnahme wird durch die gemäß der Erfindung vorgesehene Leerlaufspannungserfassung an den Fotodioden ermöglicht, weil die Leerlaufspannungen der Fotodioden im Unterschied zu den Fotoströmen unabhängig von der jeweiligen Größe der Fotodioden sind. Durch eine Reihenschaltung von n Fotodiodenelementen je Fotodiode ergibt sich eine resultierende Leerlaufspannung, die um den Faktor n höher als die Leerlaufspannung der Einzeldiodenelemente ist. Unter der Voraussetzung, daß die Gesamtgröße jeder Fotodiode unabhängig von der Anzahl ihrer Fotodiodenelemente unverändert bleibt, ist jedes Fotoelement gegenüber der Fotodiode um den Faktor n kleiner, so daß sich aufgrund der Reihenschaltung der Fotodiodenelemente die Gesamtkapazität aller parallelen Fotodioden um das $n^2$-fache der ursprünglichen Kapazität verringert und die Signalansprechgeschwindigkeit bei der Leerlaufspannungserfassung um den Faktor n gesteigert wird.

Im Hinblick auf die Verwendbarkeit der erfindungsgemäßen Vorrichtung ist gemäß einer vorteilhaften Weiterbildung vorgesehen, daß die parallel an der Ausleseschaltung liegenden Fotodioden entlang einer Zeile angeordnet sind, daß innerhalb einer Fläche entlang weiterer Zeilen eine Vielzahl von weiteren Fotodioden angeordnet ist, die zeilenweise parallel an weiteren Ausleseschaltungen angeschlossen sind und daß quer zu den Zeilen diese kreuzende einzeln steuerbare Lichttorstreifen verlaufen. Die derart ausgebildete erfindungsgemäße Vorrichtung entspricht damit in ihrem Aufbau im Prinzip der aus der eingangs bereits genannten DE-05 35 19 263 bekannten Abtasteinrichtung mit dem Unterschied, daß die Bildsensorelemente aus zeilenweise parallel geschalteten Fotodioden bestehen, deren Leerlaufspannungen erfaßt werden. Der besondere Vorteil liegt dabei in der Kombination aus der Leerlaufspannungserfassung und der sukzessiven Belichtung der Fotodioden mit Hilfe der steuerbaren Lichttorstreifen. Bei der erfindungsgemäßen Vorrichtung lassen sich die Lichttorstreifen in vorteilhafter Weise auf der Basis von Flüssigkristallen aufbauen, deren schlechter Kontrast zwischen dem lichtundurchlässigen und, dem lichtundurchlässigen Zustand von etwa 20 sich bei der Leerlaufspannungserfassung nicht gravierend auswirkt; demgegenüber wäre eine Fotostromerfassung bei einem derart schlechten Kontrast kaum möglich.

Entsprechend einer bevorzugten Ausbildung der erfindungsgemäßen Vorrichtung enthält die Ausleseschaltung einen Spannungskomparator, dessen positiver Eingang mit den Kathodenanschlüssen der parallelen Fotodioden verbunden ist und über einen steuerbaren Schalter an ein positives Referenzspannungspotential $U_{ref}$ schaltbar ist; an dem negativen Eingang des Spannungskomparators liegt ein positives Vergleichsspannungspotential $U_{comp}$ und die Fotodioden sind an ihren Anodenanschlüssen mit einem positiven Bezugsspannungspotential $U_o$ beaufschlagt, wobei $U_o > U_{ref} > U_{comp}$ ist.

Zur Erläuterung der Erfindung wird im folgenden auf die Figuren der Zeichnung Bezug genommen. Im einzelnen zeigen

Figur 1 in einem Schaltbild parallel an einer Ausleseschaltung angeschlossene Fotodioden,

Figur 2 in einem Diagramm die Strom/Spannungs-Kennliniencharakteristik der Fotodiodenanordnung nach Figur 1,

Figur 3 ein Diagramm mit den zeitlichen Verläufen der in Figur 1 bezeichneten Spannungen,

Figur 4 eine optische Vorlagenabtasteinrichtung mit Fotodioden in flächenhafter Anordnung,

Figur 5 eine Teilansicht der in Figur 4 gezeigten Fotodiodenstruktur,

Figur 6 einen Schnitt durch die Teilansicht in Figur 5 entlang der Linie AB,

Figur 7 eine alternative Ausbildung der Fotodiodenstruktur mit aus mehreren seriellen Fotodiodenelementen bestehenden Fotodioden und

Figur 8 einen Schnitt durch die Ansicht in Figur 7 entlang der Linie CD.

Figur 1 zeigt eine Mehrzahl einzelner Fotodioden 1, 2 und 3, die in Parallelschaltung mit ihren Anodenanschlüssen an einem Anschluß 4 mit dem Bezugsspannungspotential $U_o$ und mit ihren Kathodenanschlüssen an dem positiven Eingang 5 eines Spannungskomparators 6 angeschlossen sind, der eine für alle Fotodioden 1 bis 3 gemeinsame Ausleseschaltung bildet. Der negative Eingang 7 des Spannungskomparators 6 ist mit einem Vergleichspotential $U_{comp}$ beaufschlagt. Ferner ist der positive Eingang 5 des Spannungskomparators 6 über einen steuerbaren Schalter 8 an ein Referenzspannungspotential $U_{ref}$ schaltbar. Jede einzelne Fotodiode 1 bis 3 läßt sich, wie am Beispiel der mit 1 bezeichneten Fotodiode angedeutet, schaltungstechnisch als eine fotoaktive Diode 9 mit einer zu ihr parallelen Eigenkapazität 10 darstellen. Oberhalb der Reihe der Fotodioden 1 bis 3 sind diesen individuell zugeordnete Lichttorschalter 11, 12 und 13 angedeutet, die einzeln von einem lichtundurchlässigen Zustand in einen transparenten Zustand schaltbar sind und so ein sukzessives Belichten der einzelnen Fotodioden 1 bis 3 mit von ihnen in elektrische Signale umzusetzende Bildpunktinformationen ermöglichen. Mit der in Figur 1 gezeigten Anordnung lassen sich die optischen Informationen einer der Anzahl der Fotodioden 1 bis 3 entsprechenden Zahl von Bildpunkten erfassen und in elektrische Signale umwandeln, wobei aufgrund der sukzessiv nacheinander erfolgenden Belichtung der Fotodioden 1 bis 3 nur eine einzige Ausleseschaltung 6 erforderlich ist.

Figur 2 zeigt qualitativ in logarithmischer Darstellung das Strom-Spannungs-Kennlinienfeld einer Fotodiode für verschiedene, in Richtung des Pfeiles 14 ansteigende Beleuchtungsstärken, wobei $U_d$ die Spannung an der Fotodiode und $I_d$ den Strom durch die Fotodiode bezeichnen. Anhand dieses Kennlinienfeldes wird im folgenden zunächst auf das aus der eingangs genannten DE-05 36 01 658 bekannte Verfahren zum bildpunktweisen Lesen optischer Informationen eingegangen, bevor das erfindungsgemäße Verfahren erläutert wird. Wie Figur 2 zeigt, ist der Fotostrom $I_d$ beim Betreiben einer Fotodiode mit niedrigen Spannungen in Sperrichtung nahezu spannungsunabhängig und nur noch von der Beleuchtungsstärke, mit der die Fotodiode belichtet wird, abhängig. Dieser Umstand wird bei dem aus der DE-OS 36 01 658 bekannten Verfahren genutzt, indem bei negativer Spannungsbeaufschlagung der Fotodiode der negative Fotostrom $I_d$ entweder direkt oder indirekt durch Erfassung der Spannung bei Entladung der Eigenkapazität 10 (vgl. Figur 1) der Fotodiode gemessen wird. Das Verhältnis des Fotostroms $I_d$ bei heller Beleuchtung der Fotodiode zu dem Fotostrom $I_d$ bei völlig dunkel gehaltener Fotodiode, also das Verhältnis des Hellstromes zu dem Dunkelstrom kann bis zu $10^4$ betragen und stellt somit ein hohes Signal/Rausch-Verhältnis sicher.

Sobald aber im Unterschied zu dem aus der DE-OS 36 01 658 bekannten Verfahren eine Vielzahl von Fotodioden 1 bis 3, wie in Figur 1 gezeigt, parallel an einer Ausleseschaltung angeschlossen sind, würden sich bei einer Erfassung der Fotoströme $I_d$ die Dunkelströme aller jeweils unbeleuchteten Fotodioden zu einem Summenstrom addieren, der ungünstigstenfalls die gleiche Größenordnung wie der Hellstrom der jeweils beleuchteten Fotodiode aufweist. Beispielsweise würde sich bei 100 parallelen Fotodioden, von denen jeweils eine einzige Fotodiode beleuchtet wird, und bei einem Kontrast zwischen der Beleuchtungsstärke für diese beleuchtete Fotodiode und einer auf die unbeleuchteten Fotodioden auftreffenden Hintergrundbeleuchtung von 20 : 1 ein Rauschsignal ergeben, das um den Faktor 100 : 20 = 5 größer ist als das von der beleuchteten Fotodiode abgegebene Nutzsignal.

In der Schaltungsanordnung nach Figur 1 wird mit dem Komparator 6 anstelle der Fotoströme die von allen Fotodioden 1 bis 3 erzeugte Leerlaufspannung erfaßt. Im Unterschied zu den Fotoströmen ist die gemessene Leerlaufspannung keine additive Größe, sondern wird durch die jeweils am stärksten belichtete Fotodiode bestimmt. Die durch die Beleuchtung der jeweils belichteten Fotodiode, z. B. 2, von dieser erzeugte Leerlaufspannung $U_{oc}$ bewirkt eine Durchschaltung aller übrigen unbeleuchteten Fotodioden 1, 3 in Durchlaßrichtung, so daß die unbeleuchteten Fotodioden 1, 3 eine Strombelastung für die beleuchtete Fotodiode 2 darstellen; diese Strombelastung führt zu einem Spannungsabfall der von der beleuchteten Fotodiode 2 erzeugten Leerlaufspannung $U_{oc}$ auf einen geringeren Wert. Durch Messungen wurde allerdings festgestellt, daß selbst bei einer Änderung des Zahlenverhältnisses der beleuchteten Fotodioden zu der Gesamtheit aller parallel geschalteten Fotodioden, beispielsweise von 1 : 1 auf 1 : 100, die gemessene Leerlaufspannung $U_{oc}$ von 440 mV lediglich um einen Faktor < 0,3 auf 300 mV absinkt und damit wesentlich höher liegt als die gemessene Leerlaufspannung von ca. 120 mV, die durch die Hintergrundbeleuchtung von allen Fotodioden hervorgerufen wird. Es zeigt sich also, daß selbst bei einem sehr geringen Verhältnis der beleuchteten Fotodioden zu den unbeleuchteten Fotodioden der Einfluß der Strombelastung durch die jeweils unbeleuchteten Fotodioden auf die von den beleuchteten Fotodioden erzeugte Leerlaufspannung im Vergleich zur Fotostrommessung gering ist. Ferner ist auch die Auswirkung eines nur geringen Kontrastes zwischen der Beleuchtungsstärke für die beleuchteten Fotodioden und einer auf die unbeleuchteten Fotodioden fallenden Hintergrundstrahlung auf die Leerlaufspannungsmessung nur gering, weil sich, wie Figur 2 zeigt, die Hell- und Dunkelströme der Fotodioden bei ihrem Betrieb in Durchlaßrichtung nicht wesentlich unterscheiden, so daß die von der Hintergrundbeleuchtung hervorgerufenen Dunkelströme keinen erheblichen Abfall der Leerlaufspannung der jeweils belichteten Fotodioden verursachen können.

Im folgenden wird anhand von Figur 3 die Leerlaufspannungserfassung mittels der Schaltungsanordnung nach Figur 1 erläutert. Figur 3 zeigt den zeitlichen Verlauf der Spannung $U_5$ an dem positiven Eingang 5 des Komparators 6 während eines Leerlaufspannungs-Erfassungszyklus. Zu Beginn des Erfassungszyklus ist der Schalter 8 bis zum Zeitpunkt $t_1$ geschlossen, so daß an den Fotodioden 1 bis 3 in Durchlaßrichtung eine Spannung $U_d = U_o - U_{ref}$ anliegt. Die Spannungen $U_{ref}$ und $U_o$ sind derart bemessen, daß ihre Spannungsdifferenz nur geringfügig unter der bei Hintergrundbeleuchtung aller Fotodioden 1 bis 3 von diesen erzeugten Leerlaufspannung liegt. Zum Zeitpunkt $t_2$ wird der Schalter 8 geöffnet, so daß sich zwischen den Anschlüssen 4 und 5 eine Leerlaufspannung aufbaut, deren Höhe, wie obenstehend erläutert, im wesentlichen-von der Beleuchtungsstärke der am stärksten belichteten Fotodiode 2 bestimmt wird. Die Zeitkonstante, mit der sich die Leerlaufspannung aufbaut, ist u. a. von den Eigenkapazitäten 10 aller Fotodioden 1 bis 3 abhängig. Sobald die Spannung $U_5$ die Vergleichsspannung $U_{comp}$ an dem negativen Eingang 7 des Komparators 6 unterschreitet, gibt dieser ausgangsseitig ein entsprechendes elektrisches Signal ab, das eine Belichtung der Fotodiode 2 mit einer hellen Bildpunktinformation anzeigt. Der Verlauf der Spannung $U_5$ ist in Figur 3 für den Fall, daß die Fotodiode 2 mit einer relativ dunklen Bildpunktinformation, d. h. mit einer nur geringen Beleuchtungsstärke belichtet wird, gestrichelt dargestellt.

Für den Fall, daß im Sinne einer Grauwerterkennung eine Erfassung der Beleuchtungsstärke in unterschiedlichen Helligkeitsstufen erfolgen soll, ist es möglich, die Vergleichsspannung $U_{comp}$ nach Art bekannter Analog/Digital-Umsetzverfahren schrittweise zu verändern und den Umschaltpunkt des Komparators 6 in Abhängigkeit von der Höhe der Vergleichsspannung $U_{comp}$ zu bestimmen.

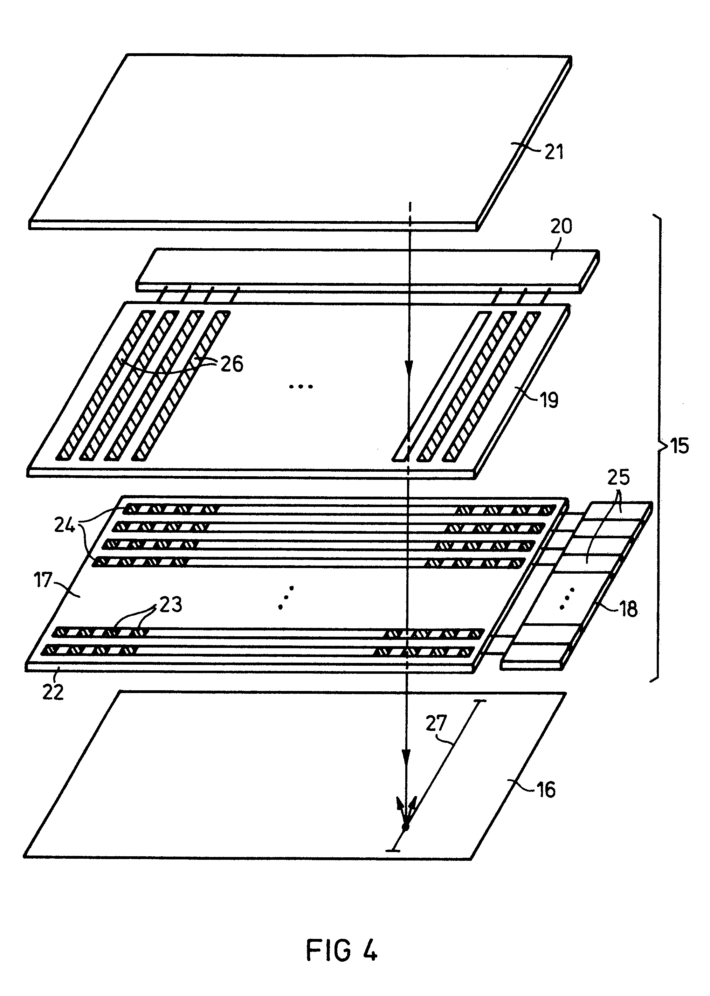

Figur 4 zeigt eine optische Vorlagenabtasteinrichtung 15 zur optischen Abtastung einer Vorlage 16 auf der Grundlage der in Figur 1 gezeigten Schaltungsanordnung. Im einzelnen besteht die Vorlagenabtasteinrichtung 15 aus einem der abzutastenden Vorlage 16 zugewandten flächenhaften Bildsensorteil 17 mit einer zugehörigen Ausleseeinrichtung 18, einem flächenhaften Lichttorteil 19 mit einer zugehörigen Steuereinrichtung 20 und einem flächenhaften Beleuchtungsteil 21 in jeweils übereinanderliegenden Ebenen. Die Teile 17 bis 21 sind lediglich zur übersichtlicheren Darstellung voneinander getrennt dargestellt; tatsächlich sind die Teil 17 bis 21 zu einem einzigen folienartigen Bauelement vereinigt, das auf die abzutastende Vorlage 16 aufgelegt wird.

Das Bildsensorteil 17 enthält eine Vielzahl von auf einer flächenhaften transparenten Trägerplatte 22 bildpunktweise angeordneten Fotodioden 23, die zeilenweise zueinander parallel geschaltet sind; dementsprechend verlaufen auf der Trägerplatte 22 des Bildsensorteils 17 eine Vielzahl von Zeilen 24 mit jeweils parallelgeschalteten Fotodioden 23 parallel zueinander. Jeder Zeile 24 ist jeweils eine eigene Ausleseschaltung 25 zugeordnet, an der die zeileneigenen parallelen Fotodioden 23 in der Weise angeschlossen sind, wie dies in Figur 1 dargestellt ist.

Das Lichttorteil 19 weist quer zur Richtung der Zeilen 24 jeweils oberhalb der transparenten Bereiche zwischen jeweils zwei benachbarten Fotodioden 23 verlaufende Lichttorstreifen 26 auf, die durch die Steuereinrichtung 20 einzeln nacheinander von einem lichtundurchlässigen Zustand in einen lichtdurchlässigen Zustand steuerbar sind. Die Lichttorstreifen 26 werden durch Flüssigkristalle innerhalb des Lichttorteils 19 gebildet, die über streifenförmige Elektroden streifenweise transparent geschaltet werden.

Das oberhalb des Lichttorteils 19 angeordnete Beleuchtungsteil 21 besteht vorzugsweise aus einer Elektrolumineszenzplatte, durch die eine gleichmäßige Ausleuchtung der Fläche des Lichttorteils 18 erreicht wird. Alternativ hierzu können andere eine flächenhafte Beleuchtung ermöglichende Lichtquellen, wie z. B. Leuchtstoffröhren, Verwendung finden.

Durch skuzessives Transparenzschalten der Lichttorstreifen 26 wird die abzutastende Lichtvorlage 16 von dem Beleuchtungsteil 21 durch die Zwischenräume zwischen den Fotodioden 23 hindurch quer zur Richtung der Zeilen 24 streifenweise beleuchtet. Ein entsprechender beleuchteter Streifen auf der Vorlage 16 ist mit den Bezugszeichen 27 bezeichnet. Das entsprechend den Bildpunktinformationen der Vorlage 16 von dieser reflektierte Licht trifft durch die transparente Trägerplatte 22 hindurch auf die dem beleuchteten Streifen 27 jeweils gegenüberliegenden Fotodioden 23, so daß je nach Lichtführung ein oder zwei Fotodioden 23 je Zelle 24 mit dem von der Vorlage 15 reflektierten Licht belichtet werden. In den betreffenden Fotodioden 23 werden beleuchtungsabhängige Leerlaufspannungen erzeugt, die in der Weise, wie anhand der Figuren 1 bis 3 obenstehend bereits ausführlich erläutert wurde, für jede Zeile 24 durch die jeweils zugeordneten Ausleseschaltungen 25 erfaßt werden.

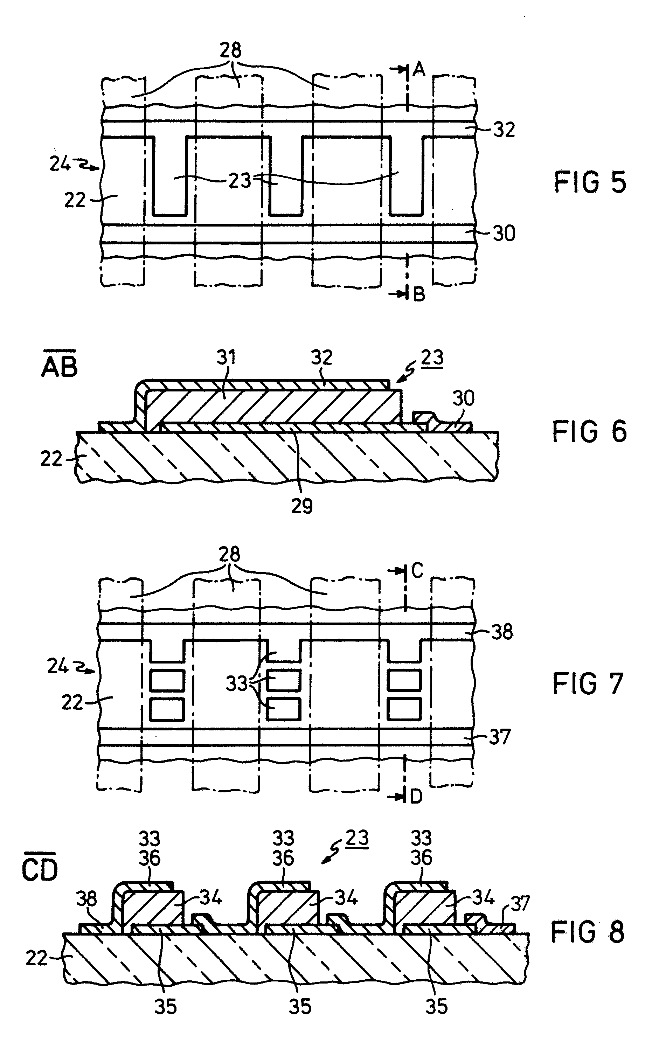

Figur 5 zeigt einen Ausschnitt aus einer der Zeilen 24 mit drei parallelen Fotodioden 23; in Figur 6 ist eine der Fotodioden 23 in Schnittdarstellung längs der Linie AB dargestellt. Die Fotodioden 23 sind in Dünnschichttechnik auf der transparenten Trägerplatte 22 realisiert, wodurch im Hinblick auf das bildpunktweise Lesen optischer Informationen sehr feine Strukturen erzielt werden können. Der Verlauf der Lichttorstreifen 26 (Figur 4) in den Zwischenräumen jeweils benachbarter Fotodioden 23 ist durch strichpunktierte Umrandungen 28 angedeutet. Im einzelnen sind auf der transparenten Trägerplatte 22, einem Glassubstrat, rechteckförmige transparente Elektroden 29 aus Palladium (Pd) oder Indium-Zinnoxid ($In_2O_3$-$SnO_2$; ITO) an den Plätzen für die Fotodioden 23 aufgebracht. Die transparenten Elektroden 29 sind an ihren Randbereichen entlang der Zeile 24 durch eine Leiterbahn 30 bestehend aus einer Chromschicht mit einer darauf aufgedampften Goldschicht miteinander verbunden. Auf jeder transparenten Elektrode 29 ist jeweils eine Schicht 31 aus wasserstoffhaltigem amorphem Silizium (a-Si:H) aufgebracht. Diese Schichten 31 sind von den Kammzinken einer ihnen gemeinsamen und in Zeilenrichtung verlaufenden kammförmigen Elektrode 32 bedeckt, die aus einer als Haftvermittler dienenden Chromschicht und einer darauf aufgedampften Goldschicht besteht. Die Elektroden 29 und 32 bilden mit dem angrenzenden amorphen Silizium jeweils Schottky-Sperrschichten, woraus die in Figur 2 gezeigte Strom/Spannungs-Kennliniencharakteristik für die Fotodioden 23 resultiert. Das durch den jeweils transparent geschalteten Lichttorstreifen 26 (vgl. Figur 4) auf die Vorlage 16 abgestrahlte und von dort reflektierte Licht trifft durch die transparente Platte 22 und die transparenten Elektroden 29 der beiderseits des Lichttorstreifens 26 liegenden Fotodioden 23 hindurch in die dortigen Schottky-Sperrschichten und generiert eine beleuchtungsabhängige Leerlaufspannung, die wie obenstehend anhand der Figuren 1 bis 3 erläutert erfaßt wird.

Alternativ zu dem Ausführungsbeispiel nach Figur 5 und 6 zeigen die Figuren 7 und 8 eine Aufteilung der Fotodioden 23 in mehrere seriell geschaltete Fotodiodenelemente 33. Wie Figur 8 in einem Schnitt entlang der Linie CD durch den in Figur 7 dargestellten Ausschnitt einer der Zeilen 24 zeigt, besteht jedes Fotodiodenelement 33 jeweils aus einer Schicht 34 aus wasserstoffhaltigem amorphen Silizium (a-Si:H), die in Dünnschichttechnik zwischen jeweils einer transparenten Elektrode 35 (Pd oder ITO) auf der transparenten Trägerplatte 22 und einer lichtundurchlässigen Elektrode 36 (Cr, Au) eingebettet sind. Die einzelnen Fotodioden 23 der Zeile 24 sind an ihren jeweils außen liegenden Fotodiodenelementen 33 durch eine die transparenten Elektroden 35 kontaktierende Leiterbahn 37 bzw. durch Ausbildung der lichtundurchlässigen Elektroden 36 als Kammzinken einer kammförmigen Elektrode 38 parallelgeschaltet. Bei den gezeigten 3 Fotodiodenelementen 33 je Fotodiode 23 erhöht sich gegenüber dem Ausführungsbeispiel nach Figur 5 und 6 die meßbare Leerlaufspannung um den Faktor 3, während aufgrund der um 1/3 kleineren Fläche der Fotodiodenelemente 33 der Fotostrom auf 1/3 und die gesamte Eigenkapazität auf 1/9 der ursprünglichen Werte verringert werden. Dadurch wird in Verbindung mit der Leerlaufspannungserfassung neben dem erhöhten Nutzsignal eine Verbesserung des dynamischen Ansprechverhaltens der Fotodiodenzeilen 24 erreicht.

## Patentansprüche

1. Verfahren zum bildpunktweisen Lesen optischer Informationen, bei dem aus einer Mehrzahl- von parallel an einer gemeinsamen Ausleseschaltung (6) angeschlossenen Bildsensorelementen (1,2,3) die einzelnen Bildsensorelemente (1,2,3) nacheinander mit den von ihnen zu erfassenden Bildpunktinformationen belichtet werden und dabei jedesmal mittels der Ausleseschaltung (6) ein von jeweils allen Bildsensorelementen (1,2,3) gemeinsam erzeugtes elektrisches Signal erfaßt wird, **dadurch gekennzeichnet, daß** als Bildsensorelemente (1,2,3) Fotodioden verwendet werden und daß mit Hilfe der Ausleseschaltung (6) die von allen Fotodioden (1,2,3) gemeinsam erzeugte Leerlaufspannung ($U_{oc}$) erfaßt wird.

2. Vorrichtung zur Durchführung des Verfahrens nach Anspruch 1, **dadurch gekennzeichnet, daß** Bildsensorelemente (1,2,3), die in einer Mehrzahl parallel an einer gemeinsamen Ausleseschaltung (6) angeschlossen und einzeln nacheinander belichtbar sind, aus Fotodioden bestehen, und daß die Ausleseschaltung (6) einen mit den Fotodioden (1,2,3) verbundenen Eingang (5) zur Leerlaufspannungserfassung aufweist.

3. Vorrichtung nach Anspruch 2, **dadurch gekennzeichnet, daß** die Fotodioden (23) jeweils aus einer Schicht (31) aus wasserstoffhaltigem amorphem Silizium (a-Si:H) bestehen, die zwischen zwei metallisch leitenden Elektroden (29) und (32) eingebettet ist, von denen eine Elektrode (29) transparent ist.

4. Vorrichtung nach Anspruch 3, **dadurch gekennzeichnet, daß** die transparente Elektrode (29) aus Indium-Zinnoxid ($In_2O_3$-$SnO_2$; ITO) besteht.

5. Vorrichtung nach Anspruch 3, **dadurch gekennzeichnet, daß** die transparente Elektrode (29) aus Palladium (Pd) besteht.

6. Vorrichtung nach einem der Ansprüche 2 bis 5, **dadurch gekennzeichnet, daß** jede Fotodiode (23) aus mindestens zwei in Serie geschalteten Fotodiodenelementen (33) besteht.

7. Vorrichtung nach einem der Ansprüche 2 bis 6, **dadurch gekennzeichnet, daß** die parallel an der Ausleseschaltung (25) liegenden Fotodioden (23) entlang einer Zeile (24) angeordnet sind, daß innerhalb einer Fläche entlang weiterer Zeilen (24) eine Vielzahl von weiteren Fotodioden (23) angeordnet sind, die zeilenweise parallel an weiteren Ausleseschaltungen (25) angeschlossen sind, und daß quer zu den Zeilen (24) diese kreuzende, einzeln steuerbare Lichttorstreifen (26) verlaufen.

8. Vorrichtung nach einem der Ansprüche 2 bis 7, **dadurch gekennzeichnet, daß** die Ausleseschaltung einen Spannungskomparator (6) enthält, dessen positiver Eingang (5) mit den Kathodenanschlüssen der Fotodioden (1,2,3) verbunden ist und über einen steuerbaren Schalter (8) an eine positive Referenzspannung ($U_{ref}$) anschließbar ist, daß an dem negativen Eingang (7) des Spannungskomparators (6) ein positives Vergleichsspannungspotential ($U_{comp}$) liegt und daß die Fotodioden (1,2,3) an ihren Anodenanschlüssen mit einem positiven Bezugsspannungspotential ($U_o$) beaufschlagt sind, wobei ($U_o > U_{ref} > U_{comp}$) ist.

FIG 1

FIG 2

FIG 3

FIG 4

FIG 5

FIG 6

FIG 7

FIG 8